# EUROPEAN PATENT APPLICATION

(11) **EP 4 294 151 A1**
(43) Date of publication of application: **20.12.2023**
(21) Application number: 22206575.7
(22) Date of filing: 10.11.2022
(51) Int. Cl.: H10K 30/10, H10K 30/40, H10K 30/85

(54) **PEROVSKITE THIN FILM SOLAR CELL AND PREPARATION METHOD THEREFOR**

(30) Priority: 17.06.2022 CN 202210683615
(71) Applicant: China Three Gorges Co., Ltd., Wuhan Hubei 430010 (CN); Ludong University, Yantai City, Shandong 264011 (CN)
(72) Inventor: WU, Yunyi, Wuhan, 430010 (CN); ZHANG, Shufang, Wuhan, 430010 (CN); YIN, Likun, Wuhan, 430010 (CN); GENG, Quanming, Wuhan, 430010 (CN); HE, Zhengyan, Wuhan, 430010 (CN)
(74) Representative: M. Zardi & Co S.A.

(57) **Abstract**

Provided in the present invention are a perovskite thin film solar cell and a preparation method therefor. The perovskite thin film solar cell includes an electron transport layer and a perovskite light-absorbing layer which are sequentially arranged on a bottom electrode, wherein a modifier layer is coated between the electron transport layer and the perovskite light-absorbing layer, and a raw material of the modifier layer is a bismuth salt solution. The preparation method for the perovskite thin film solar cell includes: before arranging a perovskite light-absorbing layer, spin-coating a bismuth salt solution on an electron transport layer and performing annealing to obtain a modifier layer, and then arranging the perovskite light-absorbing layer on the modifier layer. According to the perovskite thin film solar cell in the present invention, the problem of more interfacial defects in the perovskite thin film solar cell is remedied by using a modifier, such that the photoelectric conversion efficiency of a device is significantly improved.

## Description

### TECHNICAL FIELD

The present invention relates to the technical field of solar cells, and specifically to a perovskite thin film solar cell and a preparation method therefor.

### BACKGROUND

A structure of an organic/inorganic perovskite thin film solar cell includes from bottom to top an FTO or ITO glass substrate, an electron transport layer (ETM), a perovskite light-absorbing layer, a hole transport layer (HTM) and a metal electrode. It has attracted the attention of scientific researchers because of its excellent photoelectric performance as a next-generation photovoltaic device. A perovskite material, which is used as a solar cell light-absorbing material, has not only high efficiency in light absorption and carrier mobility, but also a tunable band gap, thus making it an excellent photovoltaic material and attracting a lot of attention. On the basis of the above-mentioned excellent performance, the perovskite material may be used as a light-absorbing material acting in a photovoltaic device. The perovskite thin film solar cell has dramatically improved the conversion efficiency in just eleven years, and has a broad development prospect in the photoelectric field.

At present, a perovskite thin film has the advantages of simple preparation and good crystallization, but in actual production, a prepared perovskite thin film still has interfacial defects, and the interfacial defects have a large impact on the photoelectric conversion efficiency of the perovskite thin film solar cell, leading to difficulties in improving the photoelectric conversion efficiency of the existing perovskite thin film solar cells.

### SUMMARY

The technical problem to be solved by the present invention lies in overcoming the interfacial defects still existing in perovskite thin films in the prior art, leading to difficulties in improving the photoelectric conversion efficiency of the existing perovskite thin film solar cells.

Thus, provided in the present invention is a perovskite thin film solar cell, including an electron transport layer and a perovskite light-absorbing layer which are sequentially arranged on a bottom electrode, wherein a modifier layer is coated between the electron transport layer and the perovskite light-absorbing layer, and a raw material of the modifier layer is a bismuth salt solution.

Optionally, the bismuth salt solution is a solution obtained by dissolving bismuth salt in ethanol, isopropanol or deionized water.

Optionally, the bismuth salt is bismuth iodide, bismuth potassium iodide and/or bismuth chloride.

Optionally, the concentration of the bismuth salt in the bismuth salt solution is 0.1-0.5 mg/mL.

Optionally, the perovskite thin film solar cell further includes a hole transport layer and a top electrode which are sequentially arranged on the perovskite light-absorbing layer, wherein the top electrode is made of one of gold, silver and copper.

Optionally, the electron transport layer is a tin oxide electron transport layer.

Further provided in the present invention is a preparation method for the perovskite thin film solar cell, including: before arranging a perovskite light-absorbing layer, spin-coating a bismuth salt solution on an electron transport layer and performing annealing to obtain a modifier layer, and then arranging the perovskite light-absorbing layer on the modifier layer.

Optionally, the preparation method further includes the steps of arranging a hole transport layer on the perovskite light-absorbing layer, and evaporating a top electrode on the hole transport layer.

Optionally, the annealing temperature after spin-coating the bismuth salt solution is 100-150°C, and the annealing time is 5-10 min.

Optionally, the perovskite light-absorbing layer is prepared on the modifier layer by spin-coating, and after a raw material of the perovskite light-absorbing layer is spin-coated, the method further includes the step of reannealing, wherein the reannealing temperature is 100-150°C, and the reannealing time is 10-15 min.

The technical solution of the present invention has the following advantages:

1. according to the perovskite thin film solar cell provided in the present invention, the surface of the electron transport layer is coated with the modifier layer which takes the bismuth salt solution as a raw material, such that the electron transport layer having a flat surface can be obtained, more trapping sites are also generated, and the perovskite light-absorbing layer is enabled to have a sufficient crystallization space, thereby obtaining a uniform and flat large-grain perovskite thin film. Therefore, the arrangement of the modifier layer in the present invention ultimately has the functions of modifying the electron transport layer, reducing interfacial defects, and further promoting the perovskite light-absorbing layer coating the modifier layer to have high flatness and large and uniform grains, thereby achieving the effect of improving the photoelectric conversion efficiency of the cell.

2. According to the preparation method for the perovskite thin film solar cell provided in the present invention, compared with a conventional preparation method, a modifier that is used can make the electron transport layer flatter and smoother, more trapping sites are generated, and a perovskite thin film having larger grains can be obtained, thus remedying the problem of more interfacial defects in the perovskite thin film solar cell, and significantly improving the photoelectric conversion efficiency thereof. Compared with an unmodified perovskite thin film solar cell, the photoelectric conversion efficiency of a modified perovskite thin film solar cell is improved by 19% or above.

### BRIEF DESCRIPTION OF THE DRAWINGS

In order to illustrate the technical solutions in the specific embodiments of the present invention or in the prior art more clearly, the drawings to be used in the description of the specific embodiments or the prior art will be briefly introduced below. Obviously, the drawings in the following description show some of the embodiments of the present invention, and those of ordinary skill in the art may also obtain other drawings from these drawings without creative efforts.
Fig. 1 is a J-V curve of a perovskite thin film solar cell in Example 1 and Comparative example 1 of the present invention.
Fig. 2 is a J-V curve of a perovskite thin film solar cell in Example 2 and Comparative example 2 of the present invention.
Fig. 3 is a J-V curve of a perovskite thin film solar cell in Example 3 and Comparative example 3 of the present invention.
Fig. 4 is a J-V curve of a perovskite thin film solar cell in Example 4 and Comparative example 4 of the present invention.
Fig. 5 is a J-V curve of a perovskite thin film solar cell in Example 5 and Comparative example 5 of the present invention.
Fig. 6 is a J-V curve of a perovskite thin film solar cell in Example 6 and Comparative example 6 of the present invention.

In Fig. 7, a is a scanning electron microscope image of the perovskite thin film solar cell in Example 1 of the present invention, and b is a scanning electron microscope image of the perovskite thin film solar cell in Comparative example 1 of the present invention.

### DETAILED DESCRIPTION

The following embodiments are provided for a better understanding of the present invention, are not limited to the best implementations, and do not constitute a limitation on the content or scope of protection of the present invention. Any product identical or similar to the present invention, derived by anyone under the inspiration of the present invention or by combining the present invention with other features of the prior art, falls within the scope of protection of the present invention.

Where specific experimental steps or conditions are not indicated in the embodiments, the operations or conditions of conventional experimental steps described in the documents in the art can be followed. The reagents or instruments used without the manufacturer indicated are conventional reagent products that can be commercially available.

PbI₂ (lead iodide, 99.99%) and FAI (formamidine iodide, CH(NH₂)₂I) are purchased from Xi'an Polymer Light Technology Corp.; a SnO₂ colloidal solution with a concentration of 15 wt% is purchased from Alpha-Iso; a Spiro-OMeTAD hole transport layer solution and FTO conductive glass are purchased from Liaoning Youxuan Company; and the remaining drugs such as methylammonium iodide (MAI, CH₃NH₃I), methylammonium bromide (MABr, CH₃NH₃Br) and methylammonium chloride (MACl, CH₃NH₃Cl), isopropyl alcohol (IPA), N,N-dimethylformamide (DMF), dimethyl sulfoxide (DMSO), bismuth iodide, bismuth potassium iodide and bismuth chloride are all purchased from TCI (TCI (Shanghai) Chemical Industry Development Co., Ltd.). All salts and solvents are used as received without further purification.

The thickness of the perovskite light-absorbing layer in the embodiments of the present invention is a conventional setting in the art. All spin-coating steps in the embodiments and the comparative examples of the present invention are operated in a vacuum glove box.

### EXAMPLE 1

Provided in this embodiment is a perovskite thin film solar cell, which uses a conventional n-i-p-type perovskite cell structure, and includes an electron transport layer and a perovskite light-absorbing layer which are sequentially arranged on a bottom electrode, and further includes a hole transport layer and a top electrode which are sequentially arranged on the perovskite light-absorbing layer.

A preparation method for the perovskite thin film solar cell includes the following steps:
1) ultrasonically cleaning FTO conductive glass for 15 min respectively by using soapy water, deionized water, anhydrous ethanol and acetone, and then irradiating the cleaned FTO conductive glass for 30 min by means of an ultraviolet ozone machine;
2) diluting an SnO₂ colloidal solution having a concentration of 15 wt% with deionized water to obtain a tin oxide solution having a concentration of 3.75 wt%, pipetting 200 µL of the prepared tin oxide solution with a pipette, spin-coating the tin oxide solution onto an FTO glass plate at 4000 rpm for 35 s, and performing annealing at 150°C for 15 min to obtain a tin oxide electron transport layer;
   dissolving 0.5 mg of bismuth iodide in 1 ml of an anhydrous ethanol solution to prepare a bismuth salt solution, pipetting 200 µL of the bismuth salt solution with a pipette, spin-coating the bismuth salt solution onto the tin oxide electron transport layer at 3000 rpm for 30 s, and then annealing the FTO conductive glass spin-coated with the bismuth salt solution at 100°C for 5 min to obtain a modifier layer;
3) dissolving 7.50 g of PbI₂ (lead iodide) and 0.30 g of CsI (cesium iodide) in a mixed solution of 11,400 µL of DMF (N,N-dimethylformamide) and 600 µL of DMSO (dimethyl sulfoxide) to obtain a mixed solution of lead iodide and cesium iodide; dissolving 0.60 g of FAI (formamidine iodide), 0.30 g of MAI (methylammonium iodide), 0.075 g of MABr (methylammonium bromide) and 0.075 g of MACl (methylammonium chloride) in 15 mL of IPA (isopropyl alcohol) to obtain a mixed solution of ammonium salts; and vigorously stirring the mixed solution of ammonium salts at 500 rpm for 5 h at room temperature;
   pipetting 50 µL of the mixed solution of lead iodide and cesium iodide with a pipette, and spin-coating the mixed solution of lead iodide and cesium iodide onto the modified electron transport layer at 3000 rpm for 30 s to obtain a thin film of lead iodide and cesium iodide; and pipetting 100 µL of the mixed solution of ammonium salts with a pipette, and spin-coating the mixed solution of ammonium salts onto the thin film of lead iodide and cesium iodide at 3000 rpm for 30 s, and then performing annealing at 150°C for 15 min to obtain a perovskite light-absorbing layer;
4) pipetting 50 µL of a Spiro-OMeTAD hole transport layer solution with a pipette, and spin-coating the Spiro-OMeTAD hole transport layer solution onto the perovskite light-absorbing layer at 3000 rpm for 30 s; and
5) evaporating a gold electrode: preparing a top electrode by using a vacuum evaporation method, wherein a material of the top electrode in this embodiment is gold, and the thickness of the gold electrode is 80 nm.

### EXAMPLE 2

A structure of a perovskite thin film solar cell provided in this embodiment is consistent with that in Example 1.

A preparation method for the perovskite thin film solar cell includes the following steps:
1) ultrasonically cleaning FTO conductive glass for 15 min respectively by using soapy water, deionized water, anhydrous ethanol and acetone, and then irradiating the cleaned FTO conductive glass for 30 min by means of an ultraviolet ozone machine;
2) diluting an SnO₂ colloidal solution having a concentration of 15 wt% with deionized water to obtain a tin oxide solution having a concentration of 3.75 wt%, pipetting 200 µL of the prepared tin oxide solution with a pipette, spin-coating the tin oxide solution onto an FTO glass plate at 4000 rpm for 35 s, and performing annealing at 150°C for 15 min to obtain a tin oxide electron transport layer;
   dissolving 0.5 mg of bismuth potassium iodide in 1 ml of an anhydrous ethanol solution to prepare a bismuth salt solution, pipetting 200 µL of the bismuth salt solution with a pipette, spin-coating the bismuth salt solution onto the tin oxide electron transport layer at 3000 rpm for 30 s, and then annealing the FTO conductive glass spin-coated with the bismuth salt solution at 150°C for 10 min to obtain a modifier layer;
3) dissolving 7.50 g of PbI₂ and 0.30 g of CsI in a mixed solution of 11,400 µL of DMF and 600 µL of DMSO to obtain a mixed solution of lead iodide and cesium iodide; dissolving 0.60 g of FAI, 0.30 g of MAI, 0.075 g of MABr and 0.075 g of MACl in 15 mL of IPA to obtain a mixed solution of ammonium salts; and vigorously stirring the mixed solution of ammonium salts at 500 rpm for 5 h at room temperature;
   pipetting 50 µL of the mixed solution of lead iodide and cesium iodide with a pipette, and spin-coating the mixed solution of lead iodide and cesium iodide onto the modified electron transport layer at 3000 rpm for 30 s to obtain a thin film of lead iodide and cesium iodide; and pipetting 100 µL of the mixed solution of ammonium salts with a pipette, and spin-coating the mixed solution of ammonium salts onto the thin film of lead iodide and cesium iodide at 3000 rpm for 30 s, and then performing annealing at 150°C for 15 min to obtain a perovskite light-absorbing layer;
4) pipetting 50 µL of a Spiro-OMeTAD hole transport layer solution with a pipette, and spin-coating the Spiro-OMeTAD hole transport layer solution onto the perovskite light-absorbing layer at 3000 rpm for 30 s; and
5) evaporating a gold electrode: preparing a top electrode by using a vacuum evaporation method, wherein a material of the top electrode in this embodiment is gold, and the thickness of the gold electrode is 80 nm.

### EXAMPLE 3

A structure of a perovskite thin film solar cell provided in this embodiment is consistent with that in Example 1.

A preparation method for the perovskite thin film solar cell includes the following steps:
1) ultrasonically cleaning FTO conductive glass for 15 min respectively by using soapy water, deionized water, anhydrous ethanol and acetone, and then irradiating the cleaned FTO conductive glass for 30 min by means of an ultraviolet ozone machine;
2) diluting an SnO₂ colloidal solution having a concentration of 15 wt% with deionized water to obtain a tin oxide solution having a concentration of 3.75 wt%, pipetting 200 µL of the prepared tin oxide solution with a pipette, spin-coating the tin oxide solution onto an FTO glass plate at 4000 rpm for 35 s, and performing annealing at 150°C for 15 min to obtain a tin oxide electron transport layer;
   dissolving 0.5 mg of bismuth chloride in 1 ml of an anhydrous ethanol solution to prepare a bismuth salt solution, pipetting 200 µL of the bismuth salt solution with a pipette, spin-coating the bismuth salt solution onto the tin oxide electron transport layer at 3000 rpm for 30 s, and then annealing the FTO conductive glass spin-coated with the bismuth salt solution at 100°C for 5 min to obtain a modifier layer;
3) dissolving 7.50 g of PbI₂ and 0.30 g of CsI in a mixed solution of 11,400 µL of DMF and 600 µL of DMSO to obtain a mixed solution of lead iodide and cesium iodide; dissolving 0.60 g of FAI, 0.30 g of MAI, 0.075 g of MABr and 0.075 g of MACl in 15 mL of IPA to obtain a mixed solution of ammonium salts; and vigorously stirring the mixed solution of ammonium salts at 500 rpm for 5 h at room temperature;
   pipetting 50 µL of the mixed solution of lead iodide and cesium iodide with a pipette, and spin-coating the mixed solution of lead iodide and cesium iodide onto the modified electron transport layer at 3000 rpm for 30 s to obtain a thin film of lead iodide and cesium iodide; and pipetting 100 µL of the mixed solution of ammonium salts with a pipette, and spin-coating the mixed solution of ammonium salts onto the thin film of lead iodide and cesium iodide at 3000 rpm for 30 s, and then performing annealing at 100°C for 10 min to obtain a perovskite light-absorbing layer;
4) pipetting 50 µL of a Spiro-OMeTAD hole transport layer solution with a pipette, and spin-coating the Spiro-OMeTAD hole transport layer solution onto the perovskite light-absorbing layer at 3000 rpm for 30 s; and
5) evaporating a gold electrode: preparing a top electrode by using a vacuum evaporation method, wherein a material of the top electrode in this embodiment is gold, and the thickness of the gold electrode is 80 nm.

### EXAMPLE 4

A structure of a perovskite thin film solar cell provided in this embodiment is consistent with that in Example 1.

A preparation method for the perovskite thin film solar cell includes the following steps:
1) ultrasonically cleaning FTO conductive glass for 15 min respectively by using soapy water, deionized water, anhydrous ethanol and acetone, and then irradiating the cleaned FTO conductive glass for 30 min by means of an ultraviolet ozone machine;
2) diluting an SnO₂ colloidal solution having a concentration of 15 wt% with deionized water to obtain a tin oxide solution having a concentration of 3.75 wt%, pipetting 200 µL of the prepared tin oxide solution with a pipette, spin-coating the tin oxide solution onto an FTO glass plate at 4000 rpm for 35 s, and performing annealing at 150°C for 15 min to obtain a tin oxide electron transport layer;
   dissolving 0.5 mg of bismuth iodide in 1 ml of an anhydrous ethanol solution to prepare a bismuth salt solution, pipetting 200 µL of the bismuth salt solution with a pipette, spin-coating the bismuth salt solution onto the tin oxide electron transport layer at 3000 rpm for 30 s, and then annealing the FTO conductive glass spin-coated with the bismuth salt solution at 100°C for 5 min to obtain a modifier layer;
3) dissolving 7.50 g of PbI₂ and 0.30 g of CsI in a mixed solution of 11,400 µL of DMF and 600 µL of DMSO to obtain a mixed solution of lead iodide and cesium iodide; dissolving 0.60 g of FAI, 0.30 g of MAI, 0.075 g of MABr and 0.075 g of MACl in 15 mL of IPA to obtain a mixed solution of ammonium salts; and vigorously stirring the mixed solution of ammonium salts at 500 rpm for 5 h at room temperature;
   pipetting 50 µL of the mixed solution of lead iodide and cesium iodide with a pipette, and spin-coating the mixed solution of lead iodide and cesium iodide onto the modified electron transport layer at 3000 rpm for 30 s to obtain a thin film of lead iodide and cesium iodide; and pipetting 100 µL of the mixed solution of ammonium salts with a pipette, and spin-coating the mixed solution of ammonium salts onto the thin film of lead iodide and cesium iodide at 3000 rpm for 30 s, and then performing annealing at 100°C for 10 min to obtain a perovskite light-absorbing layer;
4) pipetting 50 µL of a Spiro-OMeTAD hole transport layer solution with a pipette, and spin-coating the Spiro-OMeTAD hole transport layer solution onto the perovskite light-absorbing layer at 3000 rpm for 30 s; and
5) evaporating a silver electrode: preparing a top electrode by using a vacuum evaporation method, wherein the material of the top electrode in this embodiment is silver, and the thickness of a silver electrode is 80 nm.

### EXAMPLE 5

A structure of a perovskite thin film solar cell provided in this embodiment is consistent with that in Example 1.

A preparation method for the perovskite thin film solar cell includes the following steps:
1) ultrasonically cleaning FTO conductive glass for 15 min respectively by using soapy water, deionized water, anhydrous ethanol and acetone, and then irradiating the cleaned FTO conductive glass for 30 min by means of an ultraviolet ozone machine;
2) diluting an SnO₂ colloidal solution having a concentration of 15 wt% with deionized water to obtain a tin oxide solution having a concentration of 3.75 wt%, pipetting 200 µL of the prepared tin oxide solution with a pipette, spin-coating the tin oxide solution onto an FTO glass plate at 4000 rpm for 35 s, and performing annealing at 150°C for 15 min to obtain a tin oxide electron transport layer;
   dissolving 0.3 mg of bismuth potassium iodide in 1 ml of an anhydrous ethanol solution to prepare a bismuth salt solution, pipetting 200 µL of the bismuth salt solution with a pipette, spin-coating the bismuth salt solution onto the tin oxide electron transport layer at 3000 rpm for 30 s, and then annealing the FTO conductive glass spin-coated with the bismuth salt solution at 100°C for 5 min to obtain a modifier layer;
3) dissolving 7.50 g of PbI₂ and 0.30 g of CsI in a mixed solution of 11,400 µL of DMF and 600 µL of DMSO to obtain a mixed solution of lead iodide and cesium iodide; dissolving 0.60 g of FAI, 0.30 g of MAI, 0.075 g of MABr and 0.075 g of MACl in 15 mL of IPA to obtain a mixed solution of ammonium salts; and vigorously stirring the mixed solution of ammonium salts at 500 rpm for 5 h at room temperature;
   pipetting 50 µL of the mixed solution of lead iodide and cesium iodide with a pipette, and spin-coating the mixed solution of lead iodide and cesium iodide onto the modified electron transport layer at 3000 rpm for 30 s to obtain a thin film of lead iodide and cesium iodide; and pipetting 100 µL of the mixed solution of ammonium salts with a pipette, and spin-coating the mixed solution of ammonium salts onto the thin film of lead iodide and cesium iodide at 3000 rpm for 30 s, and then performing annealing at 150°C for 15 min so as to obtain a perovskite light-absorbing layer;
4) pipetting 50 µL of a Spiro-OMeTAD hole transport layer solution with a pipette, and spin-coating the Spiro-OMeTAD hole transport layer solution onto the perovskite light-absorbing layer at 3000 rpm for 30 s; and
5) evaporating a silver electrode: preparing a top electrode by using a vacuum evaporation method, wherein a material of the top electrode in this embodiment is silver, and the thickness of a silver electrode is 80 nm.

### EXAMPLE 6

A structure of a perovskite thin film solar cell provided in this embodiment is consistent with that in Example 1.

A preparation method for the perovskite thin film solar cell includes the following steps:
1) ultrasonically cleaning FTO conductive glass for 15 min respectively by using soapy water, deionized water, anhydrous ethanol and acetone, and then irradiating the cleaned FTO conductive glass for 30 min by means of an ultraviolet ozone machine;
2) diluting an SnO₂ colloidal solution having a concentration of 15 wt% with deionized water to obtain a tin oxide solution having a concentration of 3.75 wt%, pipetting 200 µL of the prepared tin oxide solution with a pipette, spin-coating the tin oxide solution onto an FTO glass plate at 4000 rpm for 35 s, and performing annealing at 150°C for 15 min to obtain a tin oxide electron transport layer;
   dissolving 0.1 mg of bismuth iodide in 1 ml of an anhydrous ethanol solution to prepare a bismuth salt solution, pipetting 200 µL of the bismuth salt solution with a pipette, spin-coating the bismuth salt solution onto the tin oxide electron transport layer at 3000 rpm for 30 s, and then annealing the FTO conductive glass spin-coated with the bismuth salt solution at 100°C for 5 min to obtain a modifier layer;
3) dissolving 7.50 g of PbI₂ and 0.30 g of CsI in a mixed solution of 11,400 µL of DMF and 600 µL of DMSO to obtain a mixed solution of lead iodide and cesium iodide; dissolving 0.60 g of FAI, 0.30 g of MAI, 0.075 g of MABr and 0.075 g of MACl in 15 mL of IPA to obtain a mixed solution of ammonium salts; and vigorously stirring the mixed solution of ammonium salts at 500 rpm for 5 h at room temperature;
   pipetting 50 µL of the mixed solution of lead iodide and cesium iodide with a pipette, and spin-coating the mixed solution of lead iodide and cesium iodide onto the modified electron transport layer at 3000 rpm for 30 s to obtain a thin film of lead iodide and cesium iodide; and pipetting 100 µL of the mixed solution of ammonium salts with a pipette, and spin-coating the mixed solution of ammonium salts onto the thin film of lead iodide and cesium iodide at 3000 rpm for 30 s, and then performing annealing at 100°C for 10 min to obtain a perovskite light-absorbing layer;
4) pipetting 50 µL of a Spiro-OMeTAD hole transport layer solution with a pipette, and spin-coating the Spiro-OMeTAD hole transport layer solution onto the perovskite light-absorbing layer at 3000 rpm for 30 s; and
5) evaporating a silver electrode: preparing a top electrode by using a vacuum evaporation method, wherein a material of the top electrode in this embodiment is silver, and the thickness of a silver electrode is 80 nm.

### COMPARATIVE EXAMPLE 1

This comparative example provides a perovskite thin film solar cell, and the only difference from Example 1 is that a modifier layer is not spin-coated on an electron transport layer.

### COMPARATIVE EXAMPLE 2

This comparative example provides a perovskite thin film solar cell, and the only difference from Example 2 is that a modifier layer is not spin-coated on an electron transport layer.

### COMPARATIVE EXAMPLE 3

This comparative example provides a perovskite thin film solar cell, and the only difference from Example 3 is that a modifier layer is not spin-coated on an electron transport layer.

### COMPARATIVE EXAMPLE 4

This comparative example provides a perovskite thin film solar cell, and the only difference from Example 4 is that a modifier layer is not spin-coated on an electron transport layer.

### COMPARATIVE EXAMPLE 5

This comparative example provides a perovskite thin film solar cell, and the only difference from Example 5 is that a modifier layer is not spin-coated on an electron transport layer.

### COMPARATIVE EXAMPLE 6

This comparative example provides a perovskite thin film solar cell, and the only difference from Example 6 is that a modifier layer is not spin-coated on an electron transport layer.

### TEST EXAMPLE 1

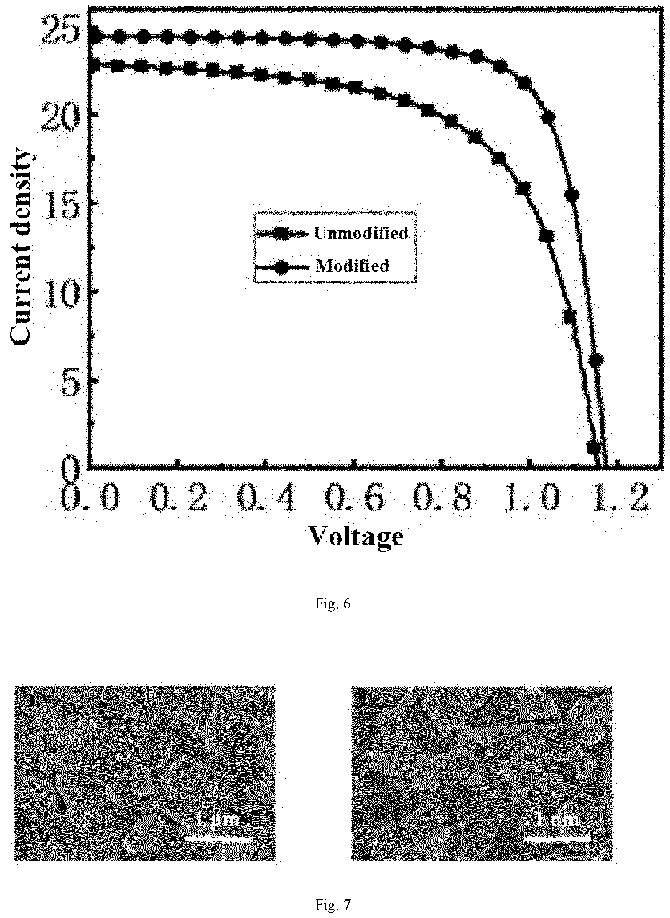

A perovskite thin film solar cell is prepared respectively by using the method in Example 1 and comparative example 1, and after a perovskite light-absorbing layer is prepared, the microscopic morphology of the perovskite light-absorbing layer is observed by using a scanning electron microscope, and the morphology thereof is shown in Fig. 7. The average grain size of a perovskite thin film in Example 1 is 1.51 µm, and the average grain size of a perovskite thin film in Comparative example 1 is 1.03 µm.

### TEST EXAMPLE 2

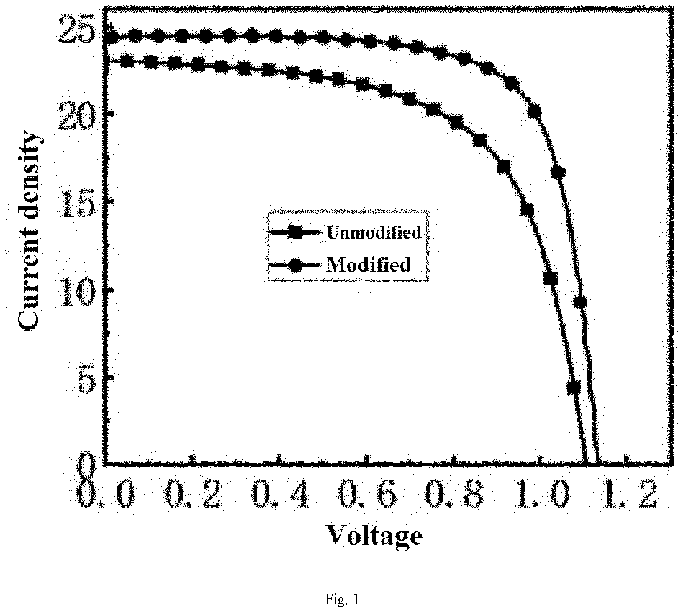

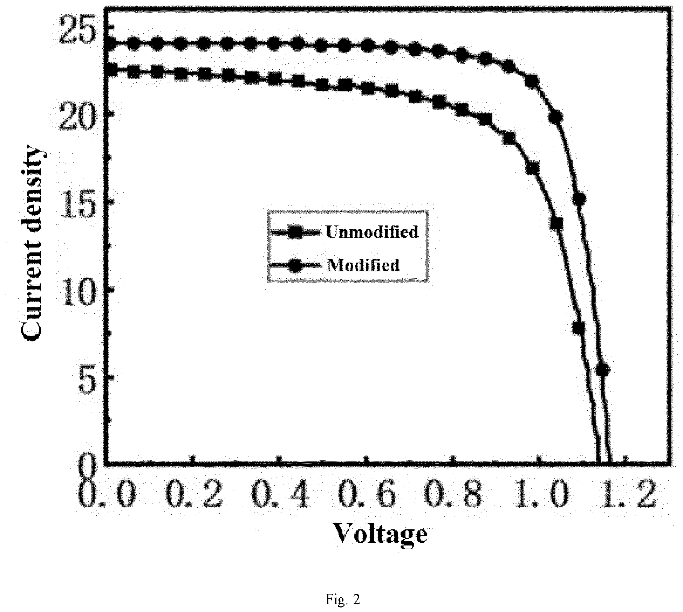

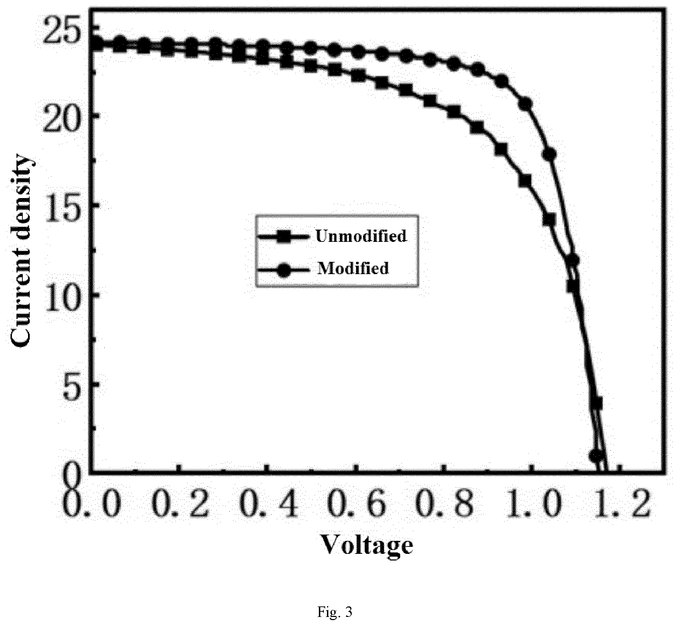

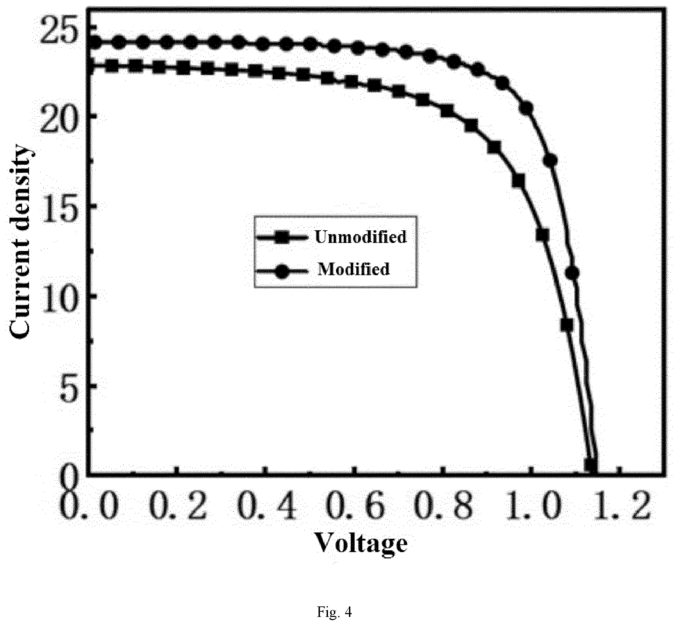

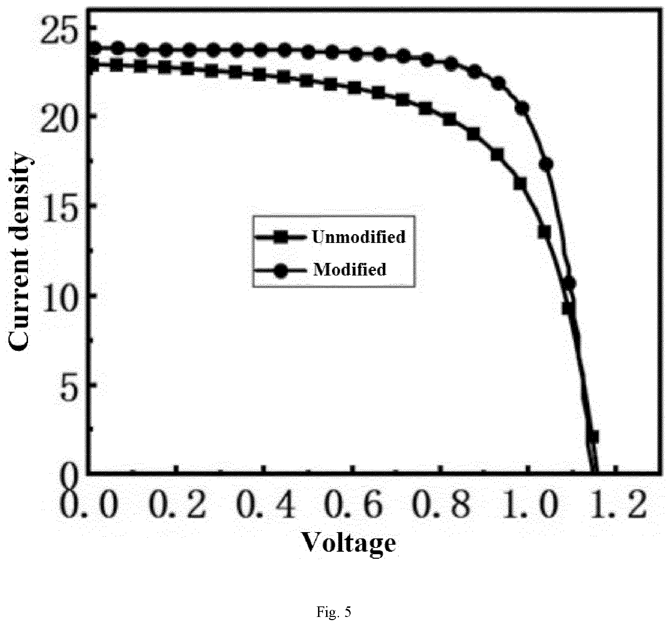

An electrochemical workstation is used to test the photoelectric conversion efficiency of the perovskite thin film solar cells prepared in the examples and the comparative examples, and the increase rate of the photoelectric conversion efficiency is respectively calculated for the examples compared with the corresponding comparative examples. A test method includes: calibrating a light intensity to AM1.5G-one sun condition (100 mW/cm²) by using a NIM-calibrated standard silicon solar cell, defining the effective active area of a perovskite thin film solar cell as 0.09 cm² by using a metal mask, and performing measurement for a J-V curve at a scan rate of 100 mV/s within the range of 1.2 V-0.1 V. The test results are shown in Figs. 1-6 and Table 1.

**Table 1. Test results for the EXAMPLES and COMPARATIVE EXAMPLES**

| Serial number | Photoelectric conversion efficiency | Increase rate |
|---|---|---|
| EXAMPLE 1 | 20.36% | 27.56% |
| COMPARATIVE EXAMPLE 1 | 15.96% | |
| EXAMPLE 2 | 21.52% | 23.32% |
| COMPARATIVE EXAMPLE 2 | 17.45% | |
| EXAMPLE 3 | 20.56% | 19.95% |
| COMPARATIVE EXAMPLE 3 | 17.14% | |
| EXAMPLE 4 | 20.53% | 19.88% |
| COMPARATIVE EXAMPLE 4 | 16.90% | |
| EXAMPLE 5 | 20.47% | 22.50% |
| COMPARATIVE EXAMPLE 5 | 16.71% | |
| EXAMPLE 6 | 21.54% | 30.86% |
| COMPARATIVE EXAMPLE 6 | 16.46% | |

Referring to Figs. 1-6 and Table 1, the photoelectric conversion efficiency of the modified perovskite thin film solar cell is improved by 19% or above compared with that of an unmodified perovskite thin film solar cell.

Obviously, the above-mentioned embodiments are merely examples made for clear description, but do not limit implementations. For those of ordinary skill in the art, other different forms of variations or modifications can also be made on the basis of the above-mentioned description. All embodiments are not necessary to be and cannot be exhaustively listed herein. In addition, the obvious variations or modifications derived therefrom all fall within the scope of protection of the present invention.

## Claims

1. A perovskite thin film solar cell, comprising an electron transport layer and a perovskite light-absorbing layer which are sequentially arranged on a bottom electrode, **characterized in that** a modifier layer is coated between the electron transport layer and the perovskite light-absorbing layer, and a raw material of the modifier layer is a bismuth salt solution;
the concentration of bismuth salt in the bismuth salt solution is 0.1-0.5 mg/mL; and
the electron transport layer is a tin oxide electron transport layer.

2. The perovskite thin film solar cell of claim 1, **characterized in that** the bismuth salt solution is a solution obtained by dissolving the bismuth salt in ethanol, isopropanol or deionized water.

3. The perovskite thin film solar cell of claim 2, **characterized in that** the bismuth salt is bismuth iodide, bismuth potassium iodide and/or bismuth chloride.

4. The perovskite thin film solar cell of claim 1, **characterized in** further comprising a hole transport layer and a top electrode which are sequentially arranged on the perovskite light-absorbing layer, wherein the top electrode is made of one of gold, silver and copper.

5. A preparation method for the perovskite thin film solar cell of any one of claims 1-4, **characterized in** comprising: before arranging a perovskite light-absorbing layer, spin-coating a bismuth salt solution on an electron transport layer and performing annealing to obtain a modifier layer, and then arranging the perovskite light-absorbing layer on the modifier layer.

6. The preparation method of claim 5, **characterized in** further comprising the steps of arranging a hole transport layer on the perovskite light-absorbing layer, and evaporating a top electrode on the hole transport layer.

7. The preparation method of claim 5 or 6, **characterized in that** the annealing temperature after spin-coating the bismuth salt solution is 100-150°C, and the annealing time is 5-10 min.

8. The preparation method of claim 5 or 6, **characterized in that** the perovskite light-absorbing layer is prepared on the modifier layer by spin-coating, and after a raw material of the perovskite light-absorbing layer is spin-coated, the method further comprises the step of reannealing, with the reannealing temperature of 100-150°C, and the reannealing time is 10-15 min.
